# EUROPÄISCHE PATENTSCHRIFT

(11) **EP 3 414 804 B1**
(45) Veröffentlichungstag und Bekanntmachung des Hinweises auf die Patenterteilung: **25.08.2021**
(21) Anmeldenummer: 17707192.5
(22) Anmeldetag: 10.02.2017
(51) Int. Cl.: H01S 5/065, H01S 5/068, H01S 5/10, H01S 5/14

(54) **LASERANORDNUNG, VERFAHREN ZUM STEUERN EINES LASERS UND MESSVERFAHREN**
LASER ARRANGEMENT, METHOD FOR CONTROLLING A LASER AND MEASURING METHOD
SYSTÈME LASER, PROCÉDÉ DE COMMANDE D'UN LASER ET PROCÉDÉ DE MESURE

(30) Priorität: 12.02.2016 DE 102016202210
(43) Veröffentlichungstag der Anmeldung: 19.12.2018
(73) Patentinhaber: Fraunhofer-Gesellschaft zur Förderung der angewandten Forschung e.V., 80686 München (DE)
(72) Erfinder: HAPPACH, Magnus, 10781 Berlin (DE); DE FELIPE MESQUIDA, David, 10119 Berlin (DE); SCHELL, Martin, 10437 Berlin (DE); KEIL, Norbert, 14089 Berlin (DE)
(74) Vertreter: Maikowski & Ninnemann Patentanwälte Partnerschaft mbB
(86) Internationale Anmeldenummer: PCT/EP2017/053051
(87) Internationale Veröffentlichungsnummer: WO 2017/137587

(56) Entgegenhaltungen:
- WO-A1-2007/123334
- US-A1- 2003 007 522
- US-A1- 2003 058 905
- DE FELIPE DAVID ET AL: "Polymer-Based External Cavity Lasers: Tuning Efficiency, Reliability, and Polarization Diversity", IEEE PHOTONICS TECHNOLOGY LETTERS, IEEE SERVICE CENTER, PISCATAWAY, NJ, US, Bd. 26, Nr. 14, 1. Juli 2014 (2014-07-01), Seiten 1391-1394, XP011551882, ISSN: 1041-1135, DOI: 10.1109/LPT.2014.2324760 [gefunden am 2014-06-19] in der Anmeldung erwähnt
- LIM YAH LENG ET AL: "Displacement and distance measurement using the change in junction voltage across a laser diode due to the self-mixing effect", SPIE - INTERNATIONAL SOCIETY FOR OPTICAL ENGINEERING. PROCEEDINGS, S P I E - INTERNATIONAL SOCIETY FOR OPTICAL ENGINEERING, US, Bd. 6038, 28. Dezember 2005 (2005-12-28), Seiten 603810-1, XP040216628, ISSN: 0277-786X, DOI: 10.1117/12.638433 ISBN: 978-1-5106-0753-8 [gefunden am 2005-12-11] in der Anmeldung erwähnt
- GOLDBERG L ET AL: "Spectral Characteristics of Semiconductor Lasers with Optical Feedback", IEEE TRANSACTIONS ON MICROWAVE THEORY AND TECHNIQUES, IEEE SERVICE CENTER, PISCATAWAY, NJ, US, Bd. 30, Nr. 4, 1. April 1982 (1982-04-01), Seiten 401-410, XP011243812, ISSN: 0018-9480 in der Anmeldung erwähnt

## Beschreibung

Die Erfindung betrifft eine Laseranordnung gemäß dem Oberbegriff des Anspruchs 1, ein Verfahren zum Steuern eines Lasers gemäß dem Oberbegriff des Anspruchs 14 sowie ein Messverfahren gemäß dem Oberbegriff des Anspruchs 15.

Aus dem Stand der Technik ist bekannt, zusätzlich zu einer internen Kavität eines Lasers eine externe Kavität vorzusehen, die zumindest einen Teil des von dem Laser emittierten Lichts zurück in die Laserkavität reflektiert. Das zurückreflektierte Licht interferiert mit dem Licht in der Laserkavität, was einen Einfluss auf die elektrische Spannung an einer aktiven Sektion des Lasers hat. Beispielsweise ist in dem Artikel "Distance Measurement using the Change in Junction Voltage Across a Laser Diode due to the Self-Mixing Effect", Lim, Yah Leng et al., Microelectronics, MEMS, and Nanotechnology, International Society for Optics and Photonics, 2005 eine mit einem Laser zusammenwirkende externe Kavität in Freistrahlanordnung beschrieben, wobei mit Hilfe der elektrischen Spannung an einer aktiven Sektion des Lasers ein Abstand eines reflektierenden Elementes der Freistrahlkavität bestimmt wird. Der Einfluss des durch eine externe Kavität rückgekoppelten Lichts auf den Laser ist auch in dem Artikel Goldberg, Lew, et al. "Spectral characteristics of semiconductor lasers with optical feed-back." Microwave Theory and Techniques, IEEE Transactions on 30.4 (1982): 401-410 beschrieben.

Darüber hinaus sind abstimmbarere External-Cavity-Laser aus der US 2003/007522 A1 und der WO 2007/123334 A1 bekannt.

Das von der Erfindung zu lösende Problem besteht darin, die der Emissionswellenlänge eines Lasers sowie Messungen mit einem Laser zu vereinfachen.

Dieses Problem wird mit der Laseranordnung mit den Merkmalen des Anspruchs 1, durch das Verfahren zum Steuern eines Lasers mit den Merkmalen des Anspruchs 14 sowie durch das Messverfahren mit den Merkmalen des Anspruchs 15 gelöst.

Danach wird eine Laseranordnung zur Verfügung gestellt, mit
- einem Laser umfassend eine Laserkavität;
- mindestens einer zu dem Laser externen Kavität, die einen Teil des vom Laser emittierten Lichts zurück in die Laserkavität reflektiert,
- einer Spannungsmessvorrichtung zum Messen einer Spannung an einer aktiven Sektion des Lasers, wobei mit Hilfe der gemessenen Spannung eine Verstimmung der Emissionswellenlänge des Lasers und/oder eine Eigenschaft eines an die externe Kavität angrenzenden Materials bestimmbar ist, wobei
- die externe Kavität einen mit dem Laser gekoppelten optischen Wellenleiter aufweist.

Bei dem optischen Wellenleiter der externen Kavität handelt es sich z.B. um einen integriert-optischen Wellenleiter oder um einen Faserwellenleiter (insbesondere eine Glasfaser, z.B. eine APC-Glasfaser).

Wie eingangs bereits erwähnt, interferiert das durch die externe Kavität in die Laserkavität zurückreflektierte Licht mit dem Licht in der Laserkavität, was zu einer Veränderung der Spannung an einer aktiven Sektion (Gainsektion) des Lasers führt. Insbesondere verändert die Interferenz die Laserbedingung, was eine Veränderung der Spannung an der aktiven Sektion des Lasers, insbesondere zu einer Abhängigkeit oder einer veränderten Abhängigkeit der Spannung an der aktiven Sektion von der Emissionswellenlänge des Lasers zur Folge hat. Entsprechend führt eine (z.B. thermisch bedingte) Veränderung (Verstimmung) der Emissionswellenlänge zu einer Veränderung der Spannung an der aktiven Sektion, so dass eine Verstimmung der Emissionswellenlänge anhand der Spannung an der aktiven Sektion bestimmbar ist. Die Spannung an der aktiven Sektion dient somit als Monitorsignal. Ein zusätzliches optisches Bauteil (wie z.B. ein Filter oder eine Fotodiode) zum Erzeugen eines Rückkopplungssignals (Monitorsignals) für die Wellenlängenstabilisierung ist somit nicht zwingend erforderlich. Vielmehr wird lediglich die Spannung an der aktiven Sektion für eine Korrektur der Emissionswellenlänge verwendet. Dies ermöglicht z.B. eine möglichst hohe Ausgangsleistung und eine möglichst kompakte Bauform des Lasers. Des Weiteren werden unerwünschte Störungen etwa durch optische Filter vermieden. Die Ausbildung der externen Kavität mit einem optischen (z.B. integriert-optischen) Wellenleiter unterstützt darüber hinaus die Realisierung einer kompakten Bauform und ermöglicht insbesondere die Realisierung einer chipintegrierten Messvorrichtung zur Bestimmung von Materialeigenschaften. Denkbar ist auch, dass die Laseranordnung mehr als eine externe Kavität aufweist. Beispielsweise sind mindestens zwei externe Kavitäten vorhanden, die unterschiedliche optische Längen aufweisen. Mit derartigen externen Kavitäten lässt ich ein Spannungssignal erzeugen, das eine Bestimmung der Wellenlänge erlaubt, so dass ein Wellenlängenmessgerät realisiert werden kann.

Beispielsweise weist der Laser als reflektierendes Resonatorelement ein Bragg-Gitter auf; zum Beispiel ist der Laser in Form eines DBR-Lasers ausgebildet. Die Interferenz des in die Laserkavität zurückreflektierten Lichts mit dem Licht in der Laserkavität führt dazu, dass die Reflektivität des Bragg-Gitters wellenlängenabhängig wird bzw. sich die Wellenlängenabhängigkeit des Bragg-Gitters verändert. Aufgrund dieser wellenlängenabhängigen Reflektivität des Bragg-Gitters verändert sich die Laserbedingung R1*R2*exp(2*L_{cav}(g-a)), wobei R1, R2 die Reflektivitäten der Resonatorspiegel, L_{cav} die Länge der Laserkavität, g die Verstärkung und a die Verluste der Laserkavität bezeichnen. Bei geringerer Reflektivität des Bragg-Gitters steigt der Verstärkungskoeffizient (Gain-Koeffizient) der aktiven Sektion des Lasers, während er bei höherer Reflektivität sinkt. Ein höherer Verstärkungsfaktor ergibt sich durch eine höhere Anzahl von Ladungsträgern im Leitungsband und macht sich daher in der an der aktiven Sektion des Lasers gemessenen Spannung bemerkbar.

Dass es sich bei dem Wellenleiter der externen Kavität um einen "integriert-optischen Wellenleiter" handeln kann, bedeutet insbesondere, dass der Wellenleiter einen auf einem Substrat ausgebildeten Kern und/oder Mantel aufweisen kann. Beispielsweise ist der integriert-optische Wellenleiter der externen Kavität auf einem Halbleitersubstrat ausgebildet, wobei der Kern und/oder der Wellenleitermantel z.B. durch mindestens eine Halbleiterschicht, Siliziumdioxid oder Siliziumnitrid gebildet ist. Denkbar ist allerdings auch, dass es sich bei dem Wellenleiter der externen Kavität um einen Polymerwellenleiter handelt.

Es wird weiter angemerkt, dass es sich bei dem Laser um einen External-Cavity-Laser handeln, d.h. um einen Laser, der selber eine externe Kavität aufweist. Diese externe Kavität ist jedoch Bestandteil der "Laserkavität" (z.B. zusammen mit einer durch die aktive Sektion des Lasers gebildeten Kavität). Entsprechend ist die externe Kavität der erfindungsgemäßen Laseranordnung verschieden von der externen Kavität des External-Cavity-Lasers.

Gemäß einer Weiterbildung der Erfindung weist die Laserkavität einen integriert-optischen Wellenleiter auf, der mit dem Wellenleiter der externen Kavität gekoppelt ist. Denkbar ist, dass die Kopplung der beiden Wellenleiter dadurch erfolgt, dass zumindest ein Teilabschnitt des Wellenleiters der externen Kavität einstückig mit dem Wellenleiter der Laserkavität ausgebildet ist, d.h. zumindest ein Teil der Laserkavität und zumindest ein Teil der externen Kavität werden durch denselben Wellenleiter gebildet. Beispielsweise ist jedoch die Laserkavität durch ein reflektierendes Element, zum Beispiel in Form eines integrierten Bragg-Gitters, von der externen Kavität abgegrenzt.

Gemäß einer anderen Ausgestaltung der Erfindung ist ein erster Teilabschnitt des Wellenleiters der externen Kavität aus einem anderen Material gebildet ist als ein zweiter Teilabschnitt des Wellenleiters. Beispielsweise ist der erste Teilabschnitt des Wellenleiters der externen Kavität auf einem ersten Substrat einstückig mit einem Wellenleiter der Laserkavität ausgebildet, während der zweite Teilabschnitt des Wellenleiters der externen Kavität auf einem zweiten (insbesondere von dem ersten Substrat verschiedenen) Substrat ausgebildet und mit dem ersten Teilabschnitt des Wellenleiters gekoppelt ist. Insbesondere besteht das zweite Substrat und/oder der zweite Teilabschnitt des Wellenleiters der externen Kavität aus einem anderen Material als das erste Substrat und/oder der erste Teilabschnitt des Wellenleiters der externen Kavität.

Denkbar ist natürlich auch, dass der gesamte Wellenleiter der externen Kavität auf einem anderen (separaten) Substrat und aus einem anderen Material ausgebildet ist als der Wellenleiter der Laserkavität. Die Kopplung zwischen der externen Kavität und der Laserkavität bzw. zwischen dem ersten und dem zweiten Teilabschnitt des Wellenleiters der externen Kavität erfolgt zum Beispiel durch eine stoffschlüssige Verbindung. Denkbar ist, dass die Kopplung mit einem optischen Koppler (z.B. einem Richtkoppler) erfolgt, der insbesondere mit auf dem Substrat (Chip) des Lasers angeordnet ist.

Die Spannung an der aktiven Sektion des Lasers hängt insbesondere von der Ausgestaltung der externen Kavität ab, wobei die Spannung wellenlängenabhängige Maxima aufweist. Gemäß einem Ausführungsbeispiel der Erfindung ist die externe Kavität so beschaffen und auf die Laserkavität abgestimmt, dass die Lage der Spannungsmaxima (d.h. die Wellenlängen, bei der die Spannung ein Maximum erreicht) zumindest näherungsweise unabhängig von der Temperatur ist. Denkbar ist hierbei, dass eine Wellenlängenstabilisierung durch Wobbeln um ein solches Maximum der Spannung herum erfolgt.

Beispielsweise weist zumindest ein Teilabschnitt des Wellenleiters der externen Kavität einen thermooptischen Koeffizienten und/oder einen thermischen Ausdehnungskoeffizienten auf, der von dem thermooptischen Koeffizienten und/oder dem thermischen Ausdehnungskoeffizienten des Wellenleiters der Laserkavität verschieden ist.

Denkbar ist auch, dass der Wellenleiter der externen Kavität wie oben beschrieben einen ersten und einen zweiten Teilabschnitt aufweist, wobei der zweite Abschnitt des Wellenleiters so beschaffen sein kann, dass er einen thermooptischen Koeffizienten und/oder einen thermischen Ausdehnungskoeffizienten aufweist, der von dem thermooptischen Koeffizienten und/oder dem thermischen Ausdehnungskoeffizienten des ersten Abschnitts des Wellenleiters verschieden ist. Beispielsweise weist der zweite Abschnitt des Wellenleiters einen dielektrischen Kern (z.B. aus Siliziumnitrid) und einen Polymermantel auf. Derartige Wellenleiter können abhängig von ihrer Dimensionierung einen negativen thermooptischen Koeffizienten besitzen.

Gemäß einer anderen Ausgestaltung der Erfindung beträgt die optische Länge der externen Kavität ein ganzzahliges Vielfaches der optischen Länge der Laserkavität. Hiermit wird erreicht, dass der Überlapp der Moden der Laserkavität und der externen Kavität möglichst groß ist, wodurch z.B. einer Beeinträchtigung der Laserstabilität und einer Verschiebung von Modensprüngen entgegengewirkt werden kann.

Denkbar ist auch, dass die optische Länge Lₑₓₜ der externen Kavität abhängig von einem gewünschten freien Spektralbereich (free spectral range - FSR) in Bezug auf Oszillationen der Spannung an der aktiven Sektion gewählt wird. Beispielsweise wird bei einem gewünschten FSR von 100 GHz eine optische Länge Lₑₓₜ von 1499 µm, bei einem FSR von 50 GHz eine optische Länge Lₑₓₜ von 2998 µm, bei einem FSR von 25 GHz eine optische Länge Lₑₓₜ von 5996 µm und bei einem FSR von 12,5 GHz eine optische Länge Lₑₓₜ von 11991 verwendet.

Die erfindungsgemäße Laseranordnung kann zudem eine Auswerteeinheit aufweisen, die dazu ausgebildet und vorgesehen ist, in Abhängigkeit von der an der aktiven Sektion gemessenen Spannung eine Veränderung der Emissionswellenlänge des Lasers (zum Beispiel aufgrund von Temperaturveränderungen) und/oder eine Eigenschaft eines an die externe Kavität angrenzenden Materials zu bestimmen. Das Bestimmen der Eigenschaft des Materials ist insbesondere deshalb möglich, da Eigenschaften oder eine Veränderung von Eigenschaften des angrenzenden Materials den effektiven Brechungsindex zumindest eines Teilabschnitts des Wellenleiters der externen Kavität und damit die Phasenverschiebung, mit der das zurückreflektierte Licht in die Laserkavität eintritt, und somit die Spannung an der aktiven Sektion des Lasers verändert. Bei der Eigenschaft handelt es sich beispielsweise um eine Materialeigenschaft (zum Beispiel eine Materialkonzentration) oder eine sonstige Größe (zum Beispiel die Temperatur und/oder eine mechanische Spannung des Materials). Bei dem zu vermessenden Material handelt es sich z.B. um eine Flüssigkeit oder ein Gas. Die erfindungsgemäße Laseranordnung ist insbesondere in einen gemeinsamen Chip integriert, so dass etwa ein on-chip Flüssigkeits- oder Gasmessgerät realisiert werden kann.

Denkbar ist auch, dass die Auswerteeinheit dazu ausgebildet und vorgesehen ist, in Abhängigkeit von der an der aktiven Sektion gemessenen Spannung die Emissionswellenlänge des Lasers zu regeln und somit zu stabilisieren. Die erfindungsgemäße Laseranordnung ist somit beispielsweise im Bereich der Nachrichtentechnik einsetzbar; z.B. als wellenlängenstabilisierter Laser in optischen Kommunikationsnetzen (etwa DWDM - Dense Wavelength Division Multiplexing) oder in der Medizin (z.B. zum Durchführen von Blutanalysen). Denkbar ist auch eine Verwendung in kohärenten optischen Systemen.

Beispielsweise besitzt der Laser eine beheizbare Phasensektion und/oder eine beheizbare Bragg-Gitter-Sektion, wobei die Auswerteeinheit ausgebildet ist, zur Regelung der Emissionswellenlänge die Temperatur der Phasensektion und/oder der Bragg-Gitter-Sektion zu verändern. Die Phasensektion und die Bragg-Gitter-Sektion weisen zum Beispiel Heizelektroden auf, die von der Auswerteeinheit angesteuert werden können. Beispielsweise bilden die Auswerteeinheit und die Spannungsmessvorrichtung eine gemeinsame Einheit (z.B. in Form einer entsprechend programmierbaren Vorrichtung).

Bei dem Laser der erfindungsgemäßen Laseranordnung handelt es sich zum Beispiel um einen Hybrid-Laser, der einen auf Basis eines Halbleitermaterials ausgebildeten ersten Wellenleiterabschnitt (der zum Beispiel die aktive Sektion des Lasers umfasst) und einen auf Basis eines Polymermaterial ausgebildeten zweiten Wellenleiterabschnitt umfasst. Denkbar ist natürlich auch, dass der Laser und auch ein Teilabschnitt der externen Kavität durchgehend aus demselben Halbleitermaterial wie Indiumphosphid bestehen, wobei jedoch das Kompensationsglied aus einem Material ausgebildet ist, das andere thermische Eigenschaften aufweist, wie oben erläutert.

Die Erfindung betrifft auch ein Verfahren zum Steuern eines External-Cavity-Lasers, insbesondere einer wie oben beschrieben ausgeführt Laseranordnung, mit den Schritten:
- Bereitstellen einer zu dem Laser externen Kavität, die einen Teil des vom Laser emittierten Lichts zurück in die Laserkavität reflektiert, wobei
- die externe Kavität verschieden von einer externen Kavität des Lasers (2) ist und einen mit dem Laser gekoppelten Wellenleiter aufweist;
- Messen einer Spannung an einer aktiven Sektion des Lasers; und
- Regeln der Emissionswellenlänge des Lasers in Abhängigkeit von der an der aktiven Sektion gemessenen Spannung.

In einem weiteren Aspekt betrifft die Erfindung auch ein Messverfahren, mit den Schritten:
- Bereitstellen einer Laseranordnung, insbesondere wie oben beschrieben, mit einem External-Cavity-Laser umfassend eine Laserkavität sowie einer zu dem Laser externen Kavität, die einen Teil des vom Laser emittierten Lichts zurück in die Laserkavität reflektiert, wobei
- die externe Kavität verschieden von einer externen Kavität des Lasers ist und einen mit dem Laser gekoppelten Wellenleiter aufweist;
- Messen einer Spannung an einer aktiven Sektion des Lasers; und
- Bestimmen mindestens einer Eigenschaft zumindest eines an die externe Kavität (insbesondere an deren Wellenleiter) angrenzenden (z.B. auf der externen Kavität bzw. deren Wellenleiter befindlichen und/oder sich zumindest abschnittsweise um die externe Kavität bzw. deren Wellenleiter herumerstreckenden) Materials.

Die oben in Bezug auf die Laseranordnung beschriebenen Weiterbildungen können natürlich analog in den erfindungsgemäßen Verfahren verwendet werden.

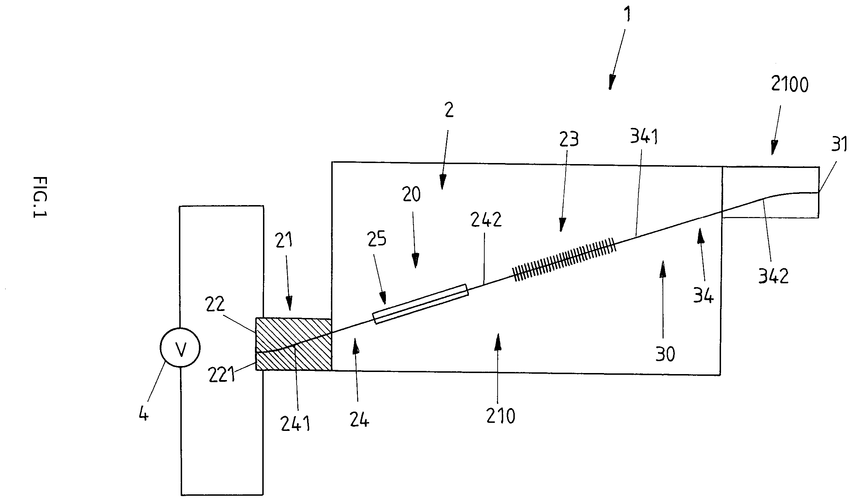

Die Erfindung wird im Folgenden anhand eines Ausführungsbeispiels unter Bezugnahme auf die einzige Figur 1 näher erläutert. Figur 1 zeigt schematisch eine Draufsicht auf eine erfindungsgemäße Laseranordnung mit einem Laser und einer externen Kavität.

Genauer umfasst die in Figur 1 dargestellte Laseranordnung 1 einen Laser in Form eines integriert-optischen hybriden DBR-Lasers 2. Der Laser 2 umfasst eine aktive Halbleitersektion 21 mit einer Stirnseite 22, die mit einer hochreflektierenden Beschichtung 221 versehen ist. Beispielsweise ist die Halbleitersektion 21 auf einem Indiumphosphid-Substrat ausgebildet. Die hochreflektierende Beschichtung 221 bildet ein erstes reflektierendes Resonatorelement einer Kavität 20 des Lasers 2.

Mit der aktiven Halbleitersektion 21 ist eine Polymersektion 210 des Lasers 2 gekoppelt, die ein Bragg-Gitter 23 umfasst, das ein zweites Resonatorelement der Kavität 20 des Lasers 2 bildet. Die Kavität 20 des Lasers 2 umfasst des Weiteren einen integriert-optischen Wellenleiters 24, der sich von der hochreflektierenden Beschichtung 221 der aktiven Sektion 21 bis zu dem Bragg-Gitter 23 erstreckt. Der Wellenleiter 24 weist einen ersten Teilabschnitt 241 auf, der im Bereich der aktiven Sektion 21 verläuft und entsprechend durch Schichten eines Halbleitermaterials ausgebildet ist. Ein zweiter Teilabschnitt 242 des Wellenleiters 24 verläuft als Polymerwellenleiter in der Polymersektion 210. Die beiden Teilabschnitte 241, 242 des Wellenleiters 24 sind miteinander gekoppelt, wobei zumindest eine Kopplungsfacette der Wellenleiterabschnitte 241, 242 eine Antireflexbeschichtungen aufweisen kann. Der Polymerwellenleiterabschnitt 242 umfasst neben dem Bragg-Gitter 23 auch eine Phasensektion 25. Sowohl das Bragg-Gitter 23 als auch die Phasensektion 25 sind beheizbar ausgestaltet, d.h. im Bereich des Bragg-Gitters 23 und der Phasensektion 25 sind Heizelektroden vorgesehen. Der grundsätzliche Aufbau des DBR-Lasers 2 ist in dem Artikel de Felipe, D. e., "Polymer-based external cavity lasers: tuning efficiency, reliability, and polarization diversity." Photonics Technology Letters, IEEE 26.14 (2014): 1391-1394, beschrieben, auf den insofern ausdrücklich Bezug genommen wird.

Die erfindungsgemäße Laseranordnung 1 umfasst des Weiteren eine externe Kavität 30, die sich von dem Bragg-Gitter 23 bis zu einem Ausgang 31 der externen Kavität 30 erstreckt. Somit bildet das Bragg-Gitter 23 gleichzeitig auch ein erstes reflektierendes Resonatorelement der externen Kavität 30, wobei ein zweites, die externe Kavität 30 begrenzendes Resonatorelement zum Beispiel durch eine entsprechend reflektierend ausgebildete Beschichtung des Ausgangs 31 oder durch ein sonstiges reflektierendes Element gebildet ist. Es wird angemerkt, dass es sich bei dem in dem oben genannten Artikel beschriebenen Laser (ähnlich dem Laser 2) um einen External-Cavity-Laser handelt, d.h. der Laser selber besitzt eine externe Kavität, die einen Teil der Laserkavität ausbildet. Diese externe Kavität des Lasers ist natürlich verschieden von der externen Kavität 30.

Die externe Kavität 30 weist ebenfalls einen integriert-optischen Wellenleiter 34 auf. Dieser integriert-optische Wellenleiter 34 besteht aus einem ersten Teilabschnitt 341, der durch eine Fortsetzung des zweiten Teilabschnitts 242 des Wellenleiters 24 der Laserkavität 20 ausgebildet ist, d.h. der erste Teilabschnitt 341 des Wellenleiters 34 der externen Kavität 30 ist einstückig mit dem zweiten Teilabschnitt 242 des Wellenleiters 24 verbunden. Ein zweiter Teilabschnitt 342 des Wellenleiters 34 der externen Kavität 30 ist hingegen nicht als Polymerwellenleiter ausgebildet, sondern ist Bestandteil einer Kompensationssektion 2100 aus einem anderen Material, die mit dem Substrat, auf dem die Polymersektion 210 des Lasers 2 ausgebildet ist, gekoppelt ist. Denkbar ist, dass die Kompensationssektion 2100 analog zur aktiven Sektion 21 des Lasers 2 auf Basis von Indiumphosphid oder eines sonstigen Halbleitermaterials ausgebildet ist. Entsprechend ist der zweite Teilabschnitt 342 des Wellenleiters 34 durch Schichten eines Halbleitermaterials gebildet.

Möglich ist allerdings auch, dass die Kompensationssektion 2100 (insbesondere der Wellenleiterabschnitt 341) auf Basis eines anderen Materials ausgebildet ist, das einen Brechungsindex, einen thermo-optischen Koeffizienten und/oder einen thermischen Ausdehnungskoeffizienten aufweist, der von den entsprechenden Koeffizienten des Lasers 2 verschieden ist. Beispielsweise kann der Wellenleiterabschnitt 34 auch auf Basis von Siliziumdioxid, Silizium, Indiumphosphid oder Siliziumnitrid ausgebildet sein. Der erste und der zweite Teilabschnitt 341,342 des Wellenleiters 34 sind insbesondere über eine stoffschlüssige Verbindung (zum Beispiel unter Verwendung eines Klebstoff) miteinander verbunden.

Wie oben bereits erwähnt, könnte die Kopplung z.B. auch mittels eines Kopplers (z.B. eines Richtkopplers, insbesondere eines gitterunterstützen Richtkopplers) erfolgen. Beispielsweise umfasst hier die externe Kavität einen Wellenleiter (zumindest einen Wellenleiterabschnitt), der z.B. mit auf dem Substrat der Laserkavität angeordnet und über den Richtkoppler mit der Laserkavität (oder dem Wellenleiterabschnitt 341) gekoppelt ist. Dieser Wellenleiter ist aus einem Material (etwa Siliziumdioxid oder Siliziumnitrid) ausgebildet, das andere thermische Eigenschaften (die oben erwähnte Koeffizienten) aufweist als der Laserwellenleiter 242. Die Kopplungsstellen zwischen der aktiven Sektion 21 und der Polymersektion 210 und/oder zwischen dem Polymerabschnitt der externen Kavität 30 und ihrer Kompensationssektion 2100 können zudem eine Antireflexionsbeschichtung aufweisen.

Denkbar ist auch, dass anstelle des integriert-optischen Teilabschnitts 341 ein Faserwellenleiter (insbesondere ein Glas- oder Polymerfaser) verwendet wird.

Die externe Kavität 30 ist so beschaffen, dass von dem Laser 2 emittiertes Licht teilweise in die Laserkavität 20 zurückreflektiert wird ("optisches Feedback"). Beispielsweise erzeugt ein Klebstoff, mit dem eine optische Faser (nicht dargestellt) mit dem Ausgang 31 der Kompensationssektion 2100 gekoppelt ist, die Rückreflexion oder reflektiert zumindest einen Teil des Lichts zurück in die Laserkavität 20.

Das zurückreflektierte Licht hat eine Wellenlängenabhängigkeit der Reflektivität des Bragg-Gitters 23 und damit der Laserbedingung zur Folge. Entsprechend wird sich eine Veränderung der Emissionswellenlänge des Lasers 2 in einer Veränderung einer elektrischen Spannung an der aktiven Sektion 21 bemerkbar machen, wie bereits oben erläutert.

Die elektrische Spannung an der aktiven Sektion 21 wird mit einer Spannungsmessvorrichtung 4 bestimmt. Beispielsweise ist die Spannungsmessvorrichtung 4 Bestandteil einer Regelung zur Stabilisierung der Emissionswellenlänge des Lasers 2. So kann die Regelung ausgebildet sein, in Abhängigkeit von der mit der Spannungsmessvorrichtung 4 bestimmten Spannung an der aktiven Sektion 21 die Heizelektroden des Bragg-Gitters 23 und/oder der Phasensektion 25 anzusteuern, um einer Veränderung der Emissionswellenlänge entgegenzuwirken, wie ebenfalls bereits oben beschrieben.

Die Polymersektion 210 des Lasers 2 (und entsprechend der mit dieser einstückig verbundenen Polymerabschnitt der externen Kavität 30) weist einen anderen thermooptischen Koeffizienten und thermischen Ausdehnungskoeffizienten auf als die aktive Sektion 21 und die Kompensationssektion 2100. Insbesondere weisen der zweite Teilabschnitt 242 des Wellenleiters 24 und entsprechend der erste Teilabschnitt 101 des Wellenleiters 34 der externen Kavität 30 einen anderen thermooptischen Koeffizienten und thermischen Ausdehnungskoeffizienten als der zweite Teilabschnitt 342 des Wellenleiters 34 auf.

Die optische Länge der externen Kavität 30 und das Material, das den zweiten Teilabschnitt 342 des Wellenleiters 34 ausbildet, sind so gewählt, dass die Phasenverschiebung des durch die externe Kavität 30 in die Laserkavität 20 zurückreflektierten Lichts gegenüber dem aus dem Laser 2 austretenden Licht auch bei einer Temperaturveränderung des Lasers 2 (d.h. der aktiven Sektion 21 und der Polymersektion 210) und der externen Kavität 30 (d.h. ihres Polymerabschnitts und der Kompensationssektion 2100) zumindest näherungsweise konstant bleibt. Dies hat den Effekt, dass die durch das zurückreflektierte Licht hervorgerufene Wellenlängenabhängigkeit des Bragg-Gitters 23 zumindest näherungsweise nicht von der Temperatur abhängt, wie ebenfalls bereits weiter oben erläutert. Somit ist das optische Feedback nicht mehr temperaturabhängig, sondern hängt nur noch von der Wellenlänge ab. Entsprechend ist es möglich, als Arbeitspunkt ein Maximum der Spannung an der aktiven Sektion zu wählen, wobei die Spannung in Folge der Wellenlängenregelung um das Maximum herum schwankt (wobbelt). Die Rückreflexion durch die externe Kavität kann auch zu einer Verringerung der Linienbreite des vom Laser emittierten Lichtes führen; z.B. um 1 MHz. Dies beeinflusst jedoch nicht die Funktion des Lasers. Beispielsweise kann als Arbeitspunkt eine Wellenlänge mit minimaler Linienbreite gewählt werden, um die "gewobbelt" wird, d.h. die konstant gehalten werden soll.

## Patentansprüche

1. Laseranordnung, mit
- einem External-Cavity-Laser (2) umfassend eine Laserkavität (20);
- mindestens einer zu dem Laser (2) externen Kavität (30), die einen Teil des vom Laser (2) emittierten Lichts zurück in die Laserkavität (20) reflektiert, wobei die zu dem Laser (2) externe Kavität (30) verschieden von einer externen Kavität des External-Cavity-Lasers (2) ist;
- einer Spannungsmessvorrichtung (4), eingerichtet zum Messen einer Spannung an einer aktiven Sektion (21) des Lasers (2), wobei mit Hilfe der gemessenen Spannung eine Verstimmung der Emissionswellenlänge des Lasers (2) und/oder eine Eigenschaft eines an die externe Kavität (30) angrenzenden Materials bestimmt wird,
**dadurch gekennzeichnet, dass**
die externe Kavität (30) einen mit dem Laser (2) gekoppelten optischen Wellenleiter (34) aufweist.

2. Laseranordnung nach Anspruch 1, **dadurch gekennzeichnet, dass** es sich bei dem optischen Wellenleiter (34) der externen Kavität (30) um einen integriert-optischen Wellenleiter oder um einen Faserwellenleiter handelt.

3. Laseranordnung nach Anspruch 1 oder 2, **dadurch gekennzeichnet, dass** die Laserkavität (20) einen integriert-optischen Wellenleiter (24) umfasst, der mit dem Wellenleiter (34) der externen Kavität (30) gekoppelt ist.

4. Laseranordnung nach Anspruch 3, **dadurch gekennzeichnet, dass** ein Teilabschnitt (341) des Wellenleiters (34) der externen Kavität (30) einstückig mit dem Wellenleiter (24) der Laserkavität (20) ausgebildet ist.

5. Laseranordnung nach einem der vorhergehenden Ansprüche, **dadurch gekennzeichnet, dass** ein erster Teilabschnitt (341) des Wellenleiters (34) der externen Kavität (30) aus einem anderen Material gebildet ist als ein zweiter Teilabschnitt (342) des Wellenleiters (34).

6. Laseranordnung nach den Ansprüche 4 und 5, **dadurch gekennzeichnet, dass** der erste Teilabschnitt des Wellenleiters (34) der externen Kavität (30) einstückig mit einem Teilabschnitt (242) des Wellenleiters (24) der Laserkavität (20) gekoppelt ist.

7. Laseranordnung nach einem der vorhergehenden Ansprüche, **dadurch gekennzeichnet, dass** zumindest ein Teilabschnitt (342) des Wellenleiters (34) der externen Kavität (30) einen thermooptischen Koeffizienten und/oder einen thermischen Ausdehnungskoeffizienten aufweist, der von dem thermooptischen Koeffizienten und/oder dem thermischen Ausdehnungskoeffizienten des Wellenleiters (24) der Laserkavität (20) verschieden ist.

8. Laseranordnung nach Anspruch 7, **dadurch gekennzeichnet, dass** der Teilabschnitt (342) des Wellenleiters (34) der externen Kavität (30) einen thermooptischen Koeffizienten und/oder thermischen Ausdehnungskoeffizienten aufweist, der von dem thermooptischen Koeffizienten und/oder dem thermischen Ausdehnungskoeffizienten des ersten Abschnitts (341) des Wellenleiters (34) der externen Kavität (30) verschieden ist.

9. Laseranordnung nach einem der vorhergehenden Ansprüche, **dadurch gekennzeichnet, dass** die optische Länge der externen Kavität (30) ein ganzzahliges Vielfaches der optischen Länge der Laserkavität (20) beträgt.

10. Laseranordnung nach einem der vorhergehenden Ansprüche, **gekennzeichnet durch** eine Auswerteeinheit, die dazu ausgebildet und vorgesehen ist, in Abhängigkeit von der an der aktiven Sektion (21) gemessenen Spannung eine Verstimmung der Emissionswellenlänge des Lasers (2) und/oder eine Eigenschaft eines an die externe Kavität (30) angrenzenden Materials zu bestimmen.

11. Laseranordnung nach Anspruch 10, **dadurch gekennzeichnet, dass** die Auswerteeinheit dazu ausgebildet und vorgesehen ist, in Abhängigkeit von der an der aktiven Sektion (21) gemessenen Spannung die Emissionswellenlänge des Lasers (2) zu regeln.

12. Laseranordnung nach Anspruch 11, **dadurch gekennzeichnet, dass** der Laser (2) eine beheizbare Phasensektion (25) und/oder eine beheizbare Bragg-Gitter-Sektion (23) aufweist, wobei die Auswerteeinheit ausgebildet ist, zur Regelung der Emissionswellenlänge die Temperatur der Phasensektion (25) und/oder der Bragg-Gitter-Sektion (23) zu verändern.

13. Laseranordnung nach einem der vorhergehenden Ansprüche, **dadurch gekennzeichnet, dass** es sich bei dem Laser (2) um einen Hybridlaser handelt, der einen auf Basis eines Halbleitermaterials ausgebildeten ersten Abschnitt (21) und einen auf Basis eines Polymermaterials ausgebildeten zweiten Abschnitt (210) umfasst.

14. Verfahren zum Steuern einer Laseranordnung nach einem der vorhergehenden Ansprüche, mit den Schritten:
- Bereitstellen einer zu dem Laser (2) externen Kavität (30), die einen Teil des vom Laser (2) emittierten Lichts zurück in die Laserkavität (20) reflektiert, wobei
- die externe Kavität (30) verschieden von einer externen Kavität des Lasers (2) ist und einen mit dem Laser (2) gekoppelten Wellenleiter (34) aufweist;
- Messen einer Spannung an einer aktiven Sektion (21) des Lasers (2); und
- Regeln der Emissionswellenlänge des Lasers (2) in Abhängigkeit von der an der aktiven Sektion (21) gemessenen Spannung.

15. Messverfahren, mit den Schritten:
- Bereitstellen einer Laseranordnung (1) nach einem der Ansprüche 1 bis 13, mit einem External-Cavity-Laser (2) umfassend eine Laserkavität (20) sowie einer zu dem Laser (2) externen Kavität (20), die einen Teil des vom Laser (2) emittierten Lichts zurück in die Laserkavität (20) reflektiert, wobei
- die externe Kavität (30) verschieden von einer externen Kavität des Lasers (2) ist und einen mit dem Laser (2) gekoppelten Wellenleiter (34) aufweist; und
- Messen einer Spannung an einer aktiven Sektion (21) des Lasers (2); und
- Bestimmen mindestens einer Eigenschaft zumindest eines an die externe Kavität (30) angrenzenden Materials durch Bestimmen einer Phasenverschiebung, mit der das zurückreflektierte Licht in die Laserkavität eintritt.

## Claims

1. Laser arrangement, comprising
- an external cavity laser (2) comprising a laser cavity (20);
- at least one cavity (30) external to the laser (2), which reflects part of the light emitted by the laser (2) back into the laser cavity (20), wherein the cavity (30) external to the laser (2) is different from an external cavity of the external cavity laser (2);
- a voltage measuring device (4), configured for measuring a voltage at an active section (21) of the laser (2), wherein a detuning of the emission wavelength of the laser (2) and/or a property of a material adjoining the external cavity (30) are/is determined with the aid of the measured voltage,
**characterized in that**
the external cavity (30) has an optical waveguide (34) coupled to the laser (2).

2. Laser arrangement according to Claim 1, **characterized in that** the optical waveguide (34) of the external cavity (30) is an integrated optical waveguide or a fibre waveguide.

3. Laser arrangement according to Claim 1 or 2, **characterized in that** the laser cavity (20) comprises an integrated optical waveguide (24) coupled to the waveguide (34) of the external cavity (30) .

4. Laser arrangement according to Claim 3, **characterized in that** a partial section (341) of the waveguide (34) of the external cavity (30) is formed integrally with the waveguide (24) of the laser cavity (20).

5. Laser arrangement according to any of the preceding claims, **characterized in that** a first partial section (341) of the waveguide (34) of the external cavity (30) is formed from a different material than a second partial section (342) of the waveguide (34) .

6. Laser arrangement according to Claims 4 and 5, **characterized in that** the first partial section of the waveguide (34) of the external cavity (30) is integrally coupled to a partial section (242) of the waveguide (24) of the laser cavity (20).

7. Laser arrangement according to any of the preceding claims, **characterized in that** at least one partial section (342) of the waveguide (34) of the external cavity (30) has a thermo-optical coefficient and/or a coefficient of thermal expansion that are/is different from the thermo-optical coefficient and/or the coefficient of thermal expansion of the waveguide (24) of the laser cavity (20).

8. Laser arrangement according to Claim 7, **characterized in that** the partial section (342) of the waveguide (34) of the external cavity (30) has a thermo-optical coefficient and/or a coefficient of thermal expansion that are/is different from the thermo-optical coefficient and/or the coefficient of thermal expansion of the first section (341) of the waveguide (34) of the external cavity (30).

9. Laser arrangement according to any of the preceding claims, **characterized in that** the optical length of the external cavity (30) is an integer multiple of the optical length of the laser cavity (20).

10. Laser arrangement according to any of the preceding claims, **characterized by** an evaluation unit configured and provided to determine a detuning of the emission wavelength of the laser (2) and/or a property of a material adjoining the external cavity (30) depending on the voltage measured at the active section (21).

11. Laser arrangement according to Claim 10, **characterized in that** the evaluation unit is configured and provided to regulate the emission wavelength of the laser (2) depending on the voltage measured at the active section (21).

12. Laser arrangement according to Claim 11, **characterized in that** the laser (2) has a heatable phase section (25) and/or a heatable Bragg grating section (23), wherein the evaluation unit is configured to vary the temperature of the phase section (25) and/or of the Bragg grating section (23) for the purpose of regulating the emission wavelength.

13. Laser arrangement according to any of the preceding claims, **characterized in that** the laser (2) is a hybrid laser comprising a first section (21) formed on the basis of a semiconductor material and a second section (210) formed on the basis of a polymer material.

14. Method for controlling a laser arrangement according to any of the preceding claims, comprising the following steps:
- providing a cavity (30) external to the laser (2), which reflects part of the light emitted by the laser (2) back into the laser cavity (20), wherein
- the external cavity (30) is different from an external cavity of the laser (2) and has a waveguide (34) coupled to the laser (2); and
- measuring a voltage at an active section (21) of the laser (2), and
- regulating the emission wavelength of the laser (2) depending on the voltage measured at the active section (21).

15. Measuring method, comprising the following steps:
- providing a laser arrangement (1) according to any of Claims 1 to 13, comprising an external cavity laser (2) comprising a laser cavity (20) and also a cavity (20) external to the laser (2), which reflects part of the light emitted by the laser (2) back into the laser cavity (20), wherein
- the external cavity (30) is different from an external cavity of the laser (2) and has a waveguide (34) coupled to the laser (2); and
- measuring a voltage at an active section (21) of the laser (2),
- determining at least one property of at least one material adjoining the external cavity (30), by determining a phase shift with which the light reflected back enters the laser cavity.

## Revendications

1. Système laser, comportant
- un laser à cavité externe (2) qui comprend une cavité laser (20) ;
- au moins une cavité (30) externe au laser (2) qui rétroréfléchit dans la cavité laser (20) une partie de la lumière émise par le laser (2), dans lequel la cavité (30) externe au laser (2) est différente d'une cavité externe du laser à cavité externe (2) ;
- un dispositif de mesure de tension (4) conçu pour mesurer une tension au niveau d'une section active (21) du laser (2), dans lequel par la tension mesurée un désaccord de la longueur d'onde d'émission du laser (2) et/ou une propriété d'un matériau adjacent à la cavité externe (30) est determiné,
**caractérisé en ce que**
la cavité externe (30) comporte un guide d'onde optique (34) couplé au laser (2).

2. Système laser selon la revendication 1, **caractérisé en ce que** le guide d'onde optique (34) de la cavité externe (30) est un guide d'onde optique intégré ou un guide d'onde à fibre.

3. Système laser selon la revendication 1 ou 2, **caractérisé en ce que** la cavité laser (20) comprend un guide d'onde optique intégré (24) qui est couplé au guide d'onde (34) de la cavité externe (30).

4. Système laser selon la revendication 3, **caractérisé en ce qu'**une section partielle (341) du guide d'onde (34) de la cavité externe (30) est formée d'un seul tenant avec le guide d'onde (24) de la cavité laser (20).

5. Système laser selon l'une des revendications précédentes, **caractérisé en ce qu'**une première section partielle (341) du guide d'onde (34) de la cavité externe (30) est formée d'un autre matériau que celui d'une seconde section partielle (342) du guide d'onde (34).

6. Système laser selon les revendications 4 et 5, **caractérisé en ce que** la première section partielle du guide d'onde (34) de la cavité externe (30) est couplée d'un seul tenant à une section partielle (242) du guide d'onde (24) de la cavité laser (20).

7. Système laser selon l'une des revendications précédentes, **caractérisé en ce qu'**au moins une section partielle (342) du guide d'onde (34) de la cavité externe (30) présente un coefficient thermo-optique et/ou un coefficient de dilatation thermique qui est différent du coefficient thermo-optique et/ou du coefficient de dilatation thermique du guide d'onde (24) de la cavité laser (20).

8. Système laser selon la revendication 7, **caractérisé en ce que** la section partielle (342) du guide d'onde (34) de la cavité externe (30) présente un coefficient thermo-optique et/ou un coefficient de dilatation thermique qui est différent du coefficient thermo-optique et/ou du coefficient de dilatation thermique de la première section (341) du guide d'onde (34) de la cavité externe (30) .

9. Système laser selon l'une des revendications précédentes, **caractérisé en ce que** la longueur optique de la cavité externe (30) est un multiple entier de la longueur optique de la cavité laser (20).

10. Système laser selon l'une des revendications précédentes, **caractérisé par** une unité d'évaluation qui est conçue et prévue pour déterminer, en fonction de la tension mesurée au niveau de la section active (21), un désaccord de la longueur d'onde d'émission du laser (2) et/ou une propriété d'un matériau adjacent à la cavité externe (30).

11. Système laser selon la revendication 10, **caractérisé en ce que** l'unité d'évaluation est conçue et prévue pour commander la longueur d'onde d'émission du laser (2) en fonction de la tension mesurée au niveau de la section active (21).

12. Système laser selon la revendication 11, **caractérisé en ce que** le laser (2) comporte une section de phase pouvant être chauffée (25) et/ou une section à réseau de Bragg pouvant être chauffée (23), dans lequel l'unité d'évaluation est conçue pour modifier la température de la section de phase (25) et/ou de la section à réseau de Bragg (23) afin de réguler la longueur d'onde d'émission.

13. Système laser selon l'une des revendications précédentes, **caractérisé en ce que** le laser (2) est un laser hybride qui comprend une première section (21) réalisée à base d'un matériau semi-conducteur et une seconde section (210) réalisée à base d'un matériau polymère.

14. Procédé de commande d'un système laser selon l'une des revendications précédentes, comprenant les étapes suivantes :
- prévoir une cavité (30) externe au laser (2), qui rétroréfléchit une partie de la lumière émise par le laser (2) dans la cavité laser (20), dans lequel
- la cavité externe (30) est différente d'une cavité externe du laser (2) et comporte un guide d'onde (34) couplé au laser (2) ; et
- mesurer une tension au niveau d'une section active (21) du laser (2), et
- réguler la longueur d'onde d'émission du laser (2) en fonction de la tension mesurée au niveau de la section active (21).

15. Procédé de mesure, comportant les étapes suivantes :
- prévoir un système laser (1) selon l'une des revendications 1 à 13, comportant un laser à cavité externe (2) comprenant une cavité laser (20) et une cavité (20) externe au laser (2) qui rétroréfléchit une partie de la lumière émise par le laser (2) dans la cavité laser (20), dans lequel
- la cavité externe (30) est différente d'une cavité externe du laser (2) et comprend un guide d'onde (34) couplé au laser (2) ; et
- mesurer une tension au niveau d'une section active (21) du laser (2), et
- déterminer au moins une propriété d'au moins un matériau adjacent à la cavité externe (30) en déterminant un déphasage avec lequel la lumière rétroréfléchie pénètre dans la cavité laser.
